# EUROPEAN PATENT APPLICATION

(11) **EP 0 558 114 A2**
(43) Date of publication of application: **01.09.1993**
(21) Application number: 93200333.8
(22) Date of filing: 08.02.1993
(51) Int. Cl.: H05K 3/28, B05D 1/18, B05D 3/06, B05C 3/10

(54) **Method and apparatus for applying and curing a coating on a circuit board**

(30) Priority: 28.02.1992 US 843385; 07.08.1992 US 926114
(71) Applicant: DELCO ELECTRONICS CORPORATION, Kokomo Indiana 46902 (US)
(72) Inventor: Litteral, Mary O'Connell, Kokomo, IN 46902 (US)
(74) Representative: Denton, Michael John

(57) **Abstract**

An automatic vertical dip coater provides for simultaneous ultraviolet curing of a conformal coating on both sides of a circuit board (18). A circuit board (18) to be coated on both sides with a conformal coating is placed on a tool (12) which is advanced towards a dip-coating tank (20) containing a ultraviolet radiation curable conformal coating (48) so that both sides of the circuit board (18) are immersed in said conformal coating to a predetermined position. The coating is then dried by means of opposed ultraviolet lamps (34,36).

## Description

This invention relates to a method and apparatus for applying and curing a coating on opposed sides of a circuit board.

Heat curing is currently the most widely used curing method for conformal coating. Most current ultraviolet curing is performed in a horizontal manner on a belt conveyor.

The present invention seeks to provide an improved method and apparatus for coating a circuit board.

According to an aspect of the present invention, there is provided a method of applying and curing a coating on opposed sides of a circuit board as specified in claim 1.

According to another aspect of the present invention, there is provided dip-coating apparatus for applying and curing a coating on opposed sides of a circuit board as specified in claim 4.

It has been found that this method can reduce the coating and curing time by 93%. For example, it has been found that the cycle can be performed in 3.5 minutes with 20 seconds of the cycle time being devoted to curing. Some prior art systems require a cycle time of 45 to 50 minutes, of which 40 to 45 minutes are devoted to curing. Moreover, circuit boards can be coated at a rate of about 1.8 metres per minute, compared to a rate of 0.5 metres per minute with some prior art systems.

In the preferred embodiment, there are provided two or more ultraviolet lamps disposed directly opposite one another, allowing circuit boards to cure on both sides at the same time. The simultaneous curing of both sides of a circuit board can prevent the dewetting problem found with systems which only cure one side of a board at a time.

Preferably, a dip coater which allows 100% solids ultraviolet curing material to be contained in an open reservoir is provided.

Advantageously, there is provided an ultraviolet oven which contains variable wattage lamps with possible settings of 100, 200 or 300 watts. Different curing steps can thus be provided for different processes and materials.

Preferably, the oven also contains a shutter system to protect the circuit boards when the conveyor is shut off and to protect the lamps from one another.

In an embodiment, there is provided a nitrogen blanket for protecting the dip tank from moisture.

A tool system including universal toolbars which remain on the equipment and individual pieces of tooling dedictated to each product, which interface with the toolbars, may be provided in some embodiments. Therefore, when changing from one product to another, only the individual tooling needs to be changed, without the need for shutting down the machine for product changeover.

Preferably, means are provided for locating, levelling and maintaining the position of a circuit board with respect to the level of coating material.

Advantageously, means are provided for cooling both the ultraviolet lamps and the circuit boards, thereby preventing any overheating of the circuit boards and enabling the system to run at a lower temperature than prior art systems of the same heating power.

A paper conveyor system is preferably provided for catching excess coating material dripping from a coated circuit board and for discarding the excess material.

Preferably, a conveyor chain is provided for conveying the boards in a manner in which they cannot hang directly above one another during any part of the cycle after being coated, including the entire curing cycle, except just prior to unloading.

A suitable conformal coating is disclosed in our copending European patent applications, EP-A-0,501,550 and EP-A-0,501,551 the disclosures of which are hereby incorporated by reference. Such a conformal coating may be a viscous, curable silicone liquid material, such as "100% Solids Silicone Conformal Coating, RTV Silicone product type, Formula No.X-125457" (Loctite Corp., Newington, CT), containing 95-100% polysiloxane, 0.1-1% photoinitiator: CAS No.6175-45-7, 0.1-1% photoinitiator: CAS No.7473-98-5, and 0.1-1% titanium derivative: CAS No.546-68-9. The conformal coating includes a moisture curing agent to cure coating underneath electronic components on the circuit boards which are not exposed to ultraviolet light. A suitable material is available from Loctite Corp. under the trade name Shadowcure 5291 ^{(RTM)}. The present invention is not limited to the use of anyone of these conformal coatings.

An embodiment of the present invention is described below, by way of illustration, with reference to the accompanying drawings, in which:
Figure 1 is an elevational view of an embodiment of dip-coating apparatus;
Figure 2 is an elevational view in cross-section of a dip tank of the apparatus of Figure 1;
Figure 3 is a front elevational view of a toolbar for use with the apparatus of Figure 1;
Figure 4 is a perspective view of a supporting tool for supporting a circuit board in the apparatus of Figure 1;
Figure 5 is a cross-sectional view of the tool of Figure 4, taken along line 5-5 of Figure 4;
Figure 6 is a perspective view of a second embodiment of supporting tool for supporting a circuit board in the apparatus of Figure 1;
Figure 7 is an elevational view of part of the apparatus of Figure 1, showing a plurality of circuit boards supported in respective tools carried by a toolbar;
Figure 8 is a side elevational view of a curing station of the apparatus of Figure 1, and
Figure 9 is a side elevational view of the curing station of Figure 8 when not in use.

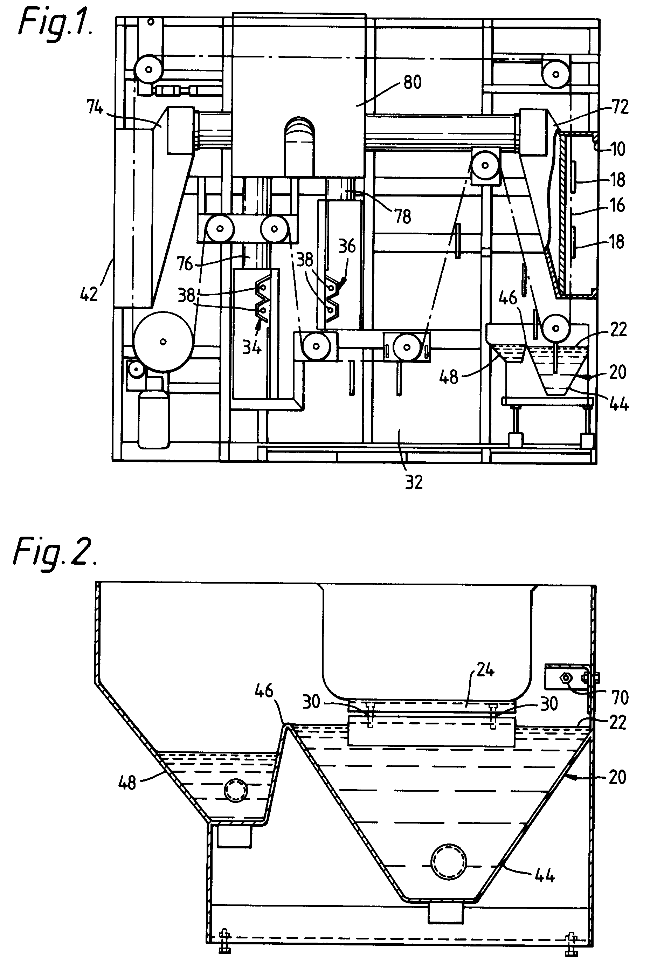

Referring to Figure 1, an automatic vertical dip coating machine with simultaneous ultraviolet curing includes a loading window 10 which provides access to a circuit board tool 12 secured to a toolbar 14 which rotates on a double conveyor chain 16, driven in conventional manner. Several toolbars 14 and circuit board tools 12 are secured at regular intervals on the conveyor chain 16. A circuit board 18 to be coated with a conformal coating is positioned on a tool 12 by an operator as the tool moves past the loading window 10. The tool 12 is then advanced towards a dip tank 20 where the circuit board 18 is immersed into conformal coating 22 to a predetermined depth.

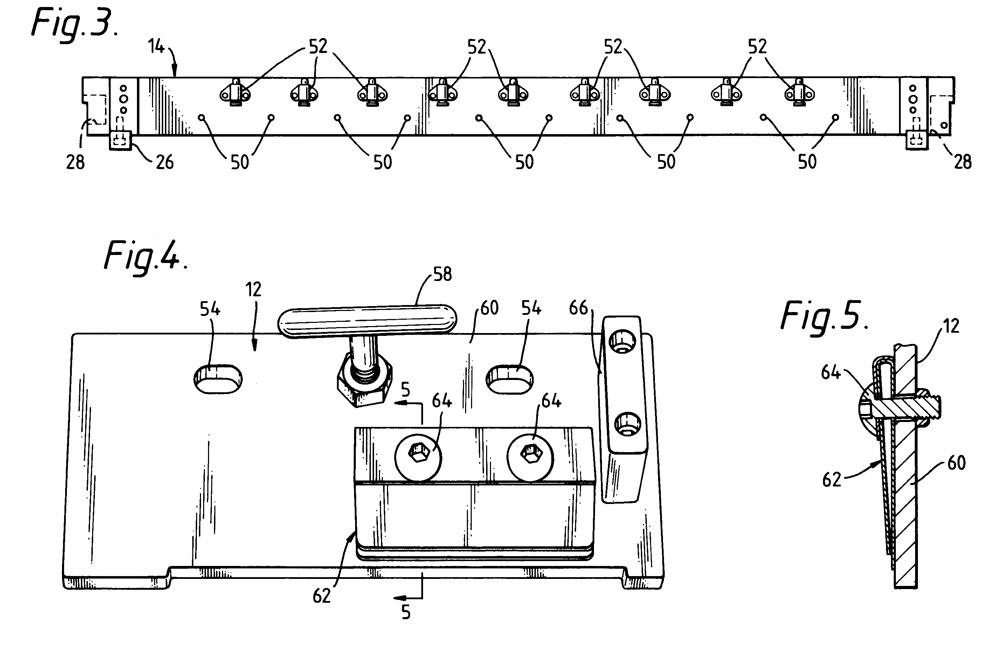

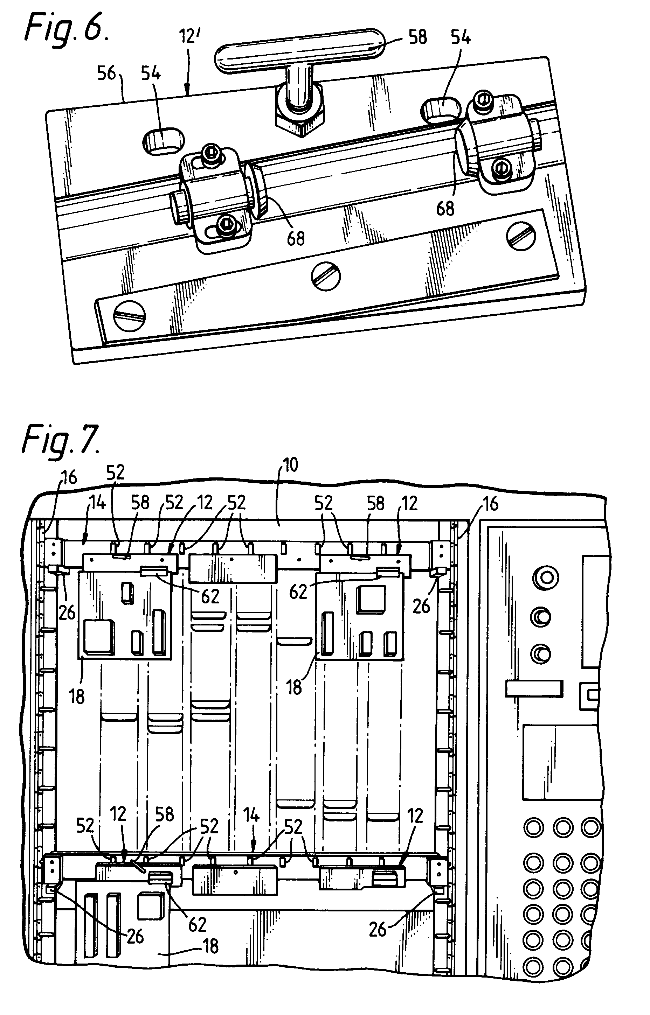

To assure that specific portions of successive boards are accurately coated each time, the system includes a graphite guide bar 24 fixed to the dip tank 20. The toolbar 14 passes across the graphite guide bar 24, preferably on toolbar blocks 26 (Figure 7), to assure that the circuit board 18 is dipped to a specific depth every time. The graphite bar 24 can be selectively adjusted vertically, as shown in the drawings, so that when the toolbar 14 rides across the guide bar 24, each circuit board 18 is accurately dipped to a predetermined depth in the coating material. The guide bar 24 is slidably secured to two shoulder pins 30 so as to be vertically adjustable. Moreover, the toolbar is formed with slots 28 (Figure 3) in each end thereof which are received in corresponding pins (not shown) on guide chain 16. This provides for about 2.5 cm (one inch) of vertical play in the movement of the toolbar 14 on the guide chain 16.

When the system is not in operation, the dip tank 20 is lowered below the chain sprocket and a lid placed on the tank to prevent the coating material from setting.

Nitrogen is still used when the lid is closed and sensors are provided to eliminate the possibility of indexing the conveyor with the lid in place.

To resume operation, the tank 20 is raised to dip the nearby circuit board into the coating material.

A nitrogen blanket of 45-51 cubic metres per hour (1600-1800 cubic feet/hour) is provided in the dip tank to prevent moisture curing of the coating in the dip tank during operation. When the coating system is not in operation and the lid is placed on the dip tank, the nitrogen blanket is reduced to 14-17 cubic metres per hour (500-600 cubic feet/hour). The nitrogen blanket is produced using a porous diffuser tube 70 made of powdered stainless steel. As a result, the velocity of the nitrogen, even at large volume rates, is approximately 60 metres per minute (200 feet per minute). The diffuser 70 can be placed just above the surface of the coating material at a distance of approximately 1 centimetre (1/2 inch) without disturbing the liquid.

The circuit board 18 is then moved by the conveyor chain 16 through a drip well area 32 (Figure 1) where excess conformal coating is allowed to drip off the circuit boards 18.

A paper conveyor system is used in this embodiment to catch excess coating material when coating drips off a circuit board 18 so as to protect the equipment. A paper roll passes through the dripwell area 32 from the front of the machine and feeds out the back of the machine.

The conveyor chain 16 is arranged so as to move either horizontally or at an angle to the vertical so that conformal coating from circuit boards secured to one toolbar does not drip onto circuit boards secured to another toolbar.

The circuit boards 18 are then advanced from the drip well area 32 to a curing station in which opposed ultraviolet light sources 34,36 cure both sides of each circuit board simultaneously. Preferably, the ultraviolet light sources 34,36 include ultraviolet lamps 38 and shutters 40 for preventing excess heating of the circuit boards and damage to the electrical components contained thereon. The shutters 40 are also constructed and arranged to prevent the opposing ultraviolet lamps 38 from subjecting one another to unnecessary exposure to ultraviolet light, thereby ensuring that the lamps 38 do not burn out too quickly.

After the curing stage, the circuit boards 18 advance to an unloading window 42 where they can be readily removed from their supporting tools 12.

The following items may be monitored on a continuous basis with appropriate displays located at an operator station:
Viscosity
Nitrogen Flow Rate
Humidity
Conveyor Speed and
Coating Level.

The system also includes a loading window ventilation hood 72, an unloading window ventilation hood 74 and lamp ventilation hoods 76,78, all connected to a central ventilation stack 80.

The position of the loading and unloading windows 10,42 may be altered in dependence upon the requirements of any particular application.

Referring now to Figure 2, the dip tank 20 includes a primary reservoir 44 which maintains the conformal coating to a sufficient level to ensure that when a circuit board is submerged in the coating, a specific portion of the circuit board is reliably covered with coating material. The dip tank 20 also includes a dam 46 and an overflow reservoir 48, thereby to maintain a constant level of coating material in the primary reservoir 44. An ultrasonic level sensor (not shown) is also provided for actuating the addition of more coating material to the dip tank 20 should the level of coating material drop below a predetermined level in the overflow reservoir 48 of the dip tank. Coating material is transferred between and to and from the two reservoirs 44,48 by means of a pumping system which includes a Teflon ^{(RTM)} coated pump, such as pump Model 100 obtainable from Trebor Inc, USA.

The pumping system allows for a minimum of 5 cm (2 inches) of adjustment to the level of the coating material in the tank. The overflow dam 46 is preferably located at the back of the dip tank 20 since the circuit boards 18 travel from the front to the back of the tank.

A recirculation system provided with the pumping system is arranged to maintain a constant liquid level that varies no more than +/- 0.5 mm (+/-0.020 inches).

An easily accessible and changeable filter system (not shown) is preferably provided, so that a filter can be changed without shutting down the equipment, for example by operating the equipment via a bypass system. The filter system of this embodiment is designed to remove tiny particles of cured coating material, thereby protecting a viscometer provided with the system and the pump. Preferably, the filter consists of a prescribed wire mesh.

An automatic material replenishment system provided with the pumping system and which does not affect the recirculation system or the liquid level is included. In use, material replacement is pumped into the recirculation pumping system.

The dip tank 20 also includes a sensor for measuring and displaying an indication of the viscosity of the coating material so as to determine when the coating material has degraded to an unacceptable level.

Referring to Figure 3, the toolbar 14 includes a plurality of pins 50 and spring loaded clamps 52 for releasably holding a supporting tool 12. The pins 50 fit into corresponding apertures 54 in the supporting tools 14, while the bevelled spring loaded clamps 52 apply a biasing force to the top edge 56 of the supporting tool so as firmly to secure the tool 12 in position on the toolbar 14. The spring loaded clamps 52 and pins 50 also function to ensure that the supporting tool 12 is properly positioned on the toolbar 14.

Referring to Figures 4 and 5, one embodiment of tool 12 includes a flat plate 60, a T-shaped handle 58, apertures 54 for receiving pins 50 of the toolbar and a U-shaped resilient clip 62. The T-shaped handle 58 is provided for assisting in pulling off the tool 12 from the toolbar 14. The tool may also include a stop 66 for aligning a circuit board 18 in the tool 12.

As shown in Figure 5, the U-shaped clip is designed such that a circuit board is inserted into the clip to a predetermined position and held there during the dipping and curing operations. The U-shaped clip is secured to the tool by a pair of screws 64.

Figure 6 shows an alternative embodiment of a tool 12 which includes a flat plate 56, a plurality of apertures for receiving pins 50 of a toolbar 14 and bevelled spring loaded clips 68. The clips 68 are arranged such that a portion of a circuit board 18 can be pushed past the bevelled surface of the clips to push the clips against their spring loading and then held in position during the dipping and curing operations.

The tools of Figures 4 to 6 are constructed and arranged so that a circuit board held therein may be easily removed at the unloading window 42.

Referring to Figure 7, a view of part of the system of Figure 1 is shown, in which two toolbars 14 are secured to the conveyor chain 16. Each toolbar 14 carries a plurality of supporting tools 12. Some of the tools 12 are shown supporting a circuit board 18.

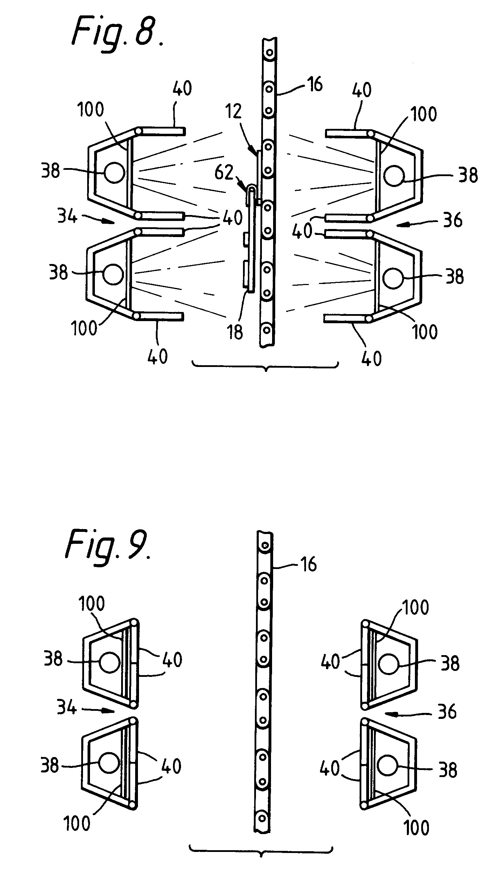

Referring to Figure 8, a side elevational view of the curing station is shown. Two pairs of ultraviolet lamp units 34,36 are shown disposed side-by-side. A circuit board 18, supported by a clip 62 of a supporting tool carried by a tool bar 12, is disposed between the two pairs of lamps 34,36. The shutters 40 of each lamp unit are open so as to allow ultraviolet light to impinge on the circuit board 18 so as to cure the coating material thereon.

The lamps 38 are diffused so as to eliminate the need for rotating the lamps.

Referring to Figure 9, which is a view similar to Figure 8, when no circuit board is located between the two pairs of lamp units 34,36, the shutters 40 are closed to prevent ultraviolet light from impinging on the opposing lamps 38, thereby prolonging the working life of the lamps 38.

The shutter mechanism is tied to the machine switch so that the circuit boards 18 are not over-exposed when the machine is turned off. The system automatically turns the lamps 38 to their lowest wattage setting when the shutters 40 are closed to maximize lamp life and minimise heat build up. When the machine is started up again, the shutters 40 open and the lamp output increased to an operating setting. For safety, the lamps 40 are also tied to all viewing windows and access panels to prevent an operator from looking into the machine while the lamps 40 are on.

The circuit boards 18 are exposed to a maximum amount of ultraviolet energy without exceeding 85°C during normal operating conditions. The low temperature is due to special quartz plates 100 located in front of the lamps 38. These plates 100 filter out the infrared wavelength portion of the spectrum which isolates most of the heat generated by the lamps 38 from the circuit boards 18. Additionally, ventilation of around 85 cubic metres per minute (3000 cubic feet per minute) also assists in minimising temperature build up.

The lamps 40 may have a minimum of three adjustable wattage settings that are controlled by a switch on a main control panel. These settings should allow for a large increase in energy (for example 100, 200, 300 watts). The emitted light and associated heat is completely isolated from the dip tank 20 and the operator.

The system includes a self-contained chiller to cool the lamps 38.

Although not apparent from Figures 8 and 9, the conveyor chain 16 passes through the curing station at an angle to the vertical, thereby ensuring that no circuit board lies directly above a subsequent circuit board on the chain.

The disclosures in United States patent application Nos.843,385 and 926,114, from which this application claims priority, and in the abstract accompanying this application are incorporated herein by reference.

## Claims

1. A method of applying and curing a coating on opposed sides of a circuit board comprising the steps of positioning a circuit board (18) on a supporting tool (12); advancing the tool to a dip-coating tank (20) containing a conformal coating (22); immersing the circuit board to a predetermined position in the tank so as to coat opposed sides of the circuit board; advancing the tool to opposed ultraviolet lamps (38); and curing the conformal coating on the opposed sides of the circuit board substantially simultaneously by means of the ultraviolet radiation emitted by the lamps.

2. A method according to claim 1, comprising the step of providing a moisture curing agent in the conformal coating.

3. A method according to claim 1 or 2, comprising the step of providing a nitrogen blanket over the conformal coating in the dip-coating tank at a rate of substantially 148 to 167 cubic metres/hour.

4. Dip-coating apparatus for applying and curing a coating on opposed sides of a circuit board comprising a supporting tool (12) for supporting a circuit board; advancing means for advancing the tool between stations of the apparatus; a coating station (20) including a dip-coating tank (20) which in use holds a conformal coating for coating a predetermined portion of a circuit board; and a curing station (34,36) including at least one pair of spaced apart opposed ultraviolet lamps (38) each including an associated shutter (40), the lamps being adapted in use substantially simultaneously to cure a coating on opposed sides of a circuit board.

5. A toolbar and tool combination comprising a toolbar (14) including a plurality of pins (50) extending therefrom; a tool (12) including a clip (62) for releasably securing a circuit board thereto; and securing means (54,58) for releasably securing the tool to the toolbar.

6. A toolbar and tool combination according to claim 5, wherein the securing means (54,58) comprises a plurality of apertures (54) in the tool for receiving corresponding pins of the toolbar, and a spring clip (52) disposed on the tool and adapted to bias the tool towards the toolbar, thereby holding the tool in position on the toolbar.

7. A toolbar and tool combination according to claim 5 or 6, wherein the tool includes a resilient U-shaped clip (62) for releasably securing a circuit board thereto.

8. A toolbar and tool combination according to claim 5 or 6, wherein the tool comprises opposed spring-loaded bevelled clips for releasably securing a circuit board thereto.
